Europäisches Patentamt

European Patent Office

Office européen des brevets

(11) Publication number: **0 285 430 B1**

# EUROPEAN PATENT SPECIFICATION

(45) Date of publication of patent specification: **05.05.93**    (51) Int. Cl.⁵: **C09J 123/12**, C08L 23/12, C08L 53/02

(21) Application number: **88302917.5**

(22) Date of filing: **31.03.88**

(54) Amorphous−polypropylene−based hot melt adhesive.

(30) Priority: **03.04.87 JP 82778/87**

(43) Date of publication of application:
**05.10.88 Bulletin 88/40**

(45) Publication of the grant of the patent:
**05.05.93 Bulletin 93/18**

(84) Designated Contracting States:
**DE ES FR GB IT NL**

(56) References cited:
**US−A− 3 686 107**

(73) Proprietor: **MINNESOTA MINING AND MANU−FACTURING COMPANY**
**3M Center, P.O. Box 33427**
**St. Paul, Minnesota 55133−3427(US)**

(72) Inventor: **Wakabayashi, Toshinori c/o Min−nesota Mining and**
**Manufacturing Co. 2501 Hudson Road P.O. Box 33 427**
**St. Paul, Minnesota 55133−3427(US)**
Inventor: **Sugii, Shinji c/o Minnesota Mining and**
**Manufacturing Co. 2501 Hudson Road P.O. Box 33 427**
**St. Paul, Minnesota 55133−3427(US)**

(74) Representative: **Baillie, Iain Cameron et al**
**c/o Ladas & Parry, Altheimer Eck 2**
**W−8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 285 430 B1

Rank Xerox (UK) Business Services
(3.10/3.6/3.3.1)

## Description

Field of Invention

The present invention relates to a composition useful as a hot melt adhesive. The present invention specifically relates to an amorphous – polypropylene – based hot melt adhesive.

Background

A hot melt adhesive typically melts sharply upon heating and flows substantially freely for application to adherends which are being bonded. Upon cooling the adhesive hardens forming the desired bond.

Hot melt adhesives have been formulated for a variety of applications, including, for example, such applications as bonding papers, wood, textiles, and corrugated paperboard. Typical adhesive compositions often contain tackifying resins and oils or waxes to, for instance, modify the viscosity of the composition or improve its adhesion to substrates. In some instances, a second polymer or elastomer may be added to modify certain properties of the adhesive.

For use in bonding such articles as machine parts and electronic components, which may be made with a variety of materials including metals and plastics, an adhesive should provide a bond having sufficient thermal and mechanical shock resistance, and shear strength. In the case of electronic or electrical components, an adhesive, in order to be suitable for such uses as attaching electronic elements to a circuit board, should provide the desired electrical properties as defined by the application, e.g., low tendency to degrade the other materials of the components, high degree of resistivity, etc., as well as have a melting point such that the composition may be applied at temperatures low enough so as to not damage the other elements of the electronic component yet such that the bond will not be broken by the temperature required for other processes to which the component is subjected during fabrication and subsequent use.

Japan Kokai No. 60 – 120775 (Inaba et al.) discloses a hot melt adhesive comprising ethylene/propylene copolymer, atactic polypropylene, tackifier, and thermoplastic elastomer such as styrene – butadiene – styrene as a filler. Such compositions typically do not provide sufficient creep resistance, particularly under elevated temperatures. Furthermore, the electrical characteristics of such compositions may not be within ranges typically desired for use in electronic components.

Japan Kokai No. 58 – 23865 (Okude et al.) discloses hot melt adhesives toughened with particles of vulcanized rubber (5 to 200 mesh) to improve the elasticity of the adhesive and the bonds provided therewith. Adhesive compositions of the type disclosed in the reference typically do not achieve the degree of thermal and/or mechanical shock resistance, and shear strengths, particularly at low temperatures, that may be desired.

US – A – 3,686,107 discloses a pressure sensitive adhesive containing amorphous polypropylene, styrene based thermoplastic polymers and tackifier but does not teach an appropriate range of tackifier or presence of wax as in the present invention nor the advantageous electrical properties of the hot melt adhesive of the invention.

Summary of Invention

The present invention provides a novel composition useful as a hot melt adhesive, and articles fabricated therewith. The hot melt adhesives provided by the invention are suitable for many applications wherein a strong shock resistant, thermally stable bond is desired. Typical applications include such uses as bonding electronic components or machine parts.

In brief summary, the composition of the invention typically consists essentially of the following: (a) amorphous polypropylene; (b) styrene – based thermoplastic elastomer (as defined hereinafter); (c) tackifier; and (d) wax; wherein said composition has a dissipation factor of 0.010 or less at 1 kilohertz at 23˚C, and a volume resistivity of at least $1 \times 10^{14}$ ohm – cm at 23˚C.

Such adhesives are particularly useful for bonding electronic components because they typically provide high peel strength, high low – temperature shear strength, excellent thermal shock resistance, high resistance to creep at elevated temperatures, and high mechanical shock resistance, especially at low temperatures, e.g., – 40˚C, and because they are substantially non – corrosive to copper. Further, such adhesives will effectively wet a variety of adherends, thereby providing effective adhesion thereto. More – over, such adhesives may be used to form bonds that will resist such elevated temperatures as may typically be encountered during the fabrication of electronic components and their use, and yet provide good low temperature properties as described herein. Thus the hot melt adhesive compositions disclosed herein provide desired bond characteristics over a useful range of temperatures.

## Brief Description of Drawing

The invention will be further explained with reference to the drawing, wherein:

Figure 1 is a schematic view of a test electrode of the type used in the Residual Insulation Test for electrolytic corrosion discussed in the Examples.

Figures 2−5 are photomicrographs of adhesive compositions of the invention taken with a transmission−type electron microscope illustrating the discrete domains formed therein.

These Figures are intended to be merely illustrative and are not limiting.

## Detailed Description of Invention

As described above, the hot melt adhesive of the invention is a composition typically consisting essentially of the following: (a) amorphous polypropylene; (b) styrene−based thermoplastic elastomer (as hereinafter defined); (c) tackifier; and (d) wax; wherein said composition has a dissipation factor of 0.010 or less at 1 kilohertz at 23°C, and a volume resistivity of at least about $1 \times 10^{14}$ ohm−cm at 23°C.

Adhesive compositions formulated according to the invention will typically also have a volume resistivity between $10^{14}$ and $10^{17}$ ohm−centimeter at 23°C, dielectric strength between 25 and 50 kilovolts/millimeter, dielectric constant between 2.3 and 3.0 at 1 kilohertz, dielectric lost tangent (or dissipation factor) between 0.0008 and 0.010 at 1 kilohertz at 23°C, and electrolytic corrosion as measured by the "Residual Insulation Test" after 1000 hours of between $10^{10}$ and $10^{12}$ ohm.

An amorphous polypropylene which may be used in the composition of the invention is atactic polypropylene, having a weight average molecular weight between 10,000 and 100,000, and more preferably between 10,000 and 50,000. At substantially lower molecular weights, the resultant adhesive composition may tend to have poorer physical properties, e.g., lower strengths and resistance to shock. At substantially higher molecular weights, the viscosity of the composition may tend to be too high for convenient processing and handling during production of the adhesive.

Atactic polypropylene is essentially a non−crystalline, i.e., amorphous, form of polypropylene formed in comparatively small amounts during the production of isotactic polypropylene, a more crystalline form of polypropylene, by stereospecific polymerization of propylene. Examples of commercially available amorphous polypropylene resins which are suitable for use in the invention include the following: EASTOBOND Series M−5W, M−500, and G−92, available from Eastman Chemical Products, Inc.; POLYTAC R Series, SUPERTAC, and POLYMER C polypropylenes, available from Crowley Chemical Company; and A−FAX 500, 600, 800, and 940 Polypropylenes, available from Hercules Inc.

Another example of amorphous polypropylene suitable for use in compositions of the invention is propylene copolymerized with low molecular weight alkenes, e.g., ethylene or 1−butene, such as Amorphous Poly Alpha Olefin commercially available from El Paso Products Company.

Adhesive compositions of the invention contain between 10 and 70 weight percent, and preferably between 14 and 50 weight percent, of amorphous polypropylene. At substantially higher levels of amorphous polypropylene, the resultant composition may tend to be too soft and have lower strengths, whereas at substantially lower levels of amorphous polypropylene, the resultant composition may tend to be too brittle. The polypropylene component of such adhesive compositions may include minor amounts, typically about 10 weight percent thereof or less, preferably less than about 2 weight percent, of other forms of polypropylene, e.g., isotactic or syndiotactic polypropylenes, which tend to be more crystalline in nature. Higher amounts of such forms of polypropylene may tend to impart a more crystalline nature to the resultant adhesive composition, thereby rendering same more brittle and less useful as hot melt adhesive.

Adhesive compositions of the invention further contain a styrene−based thermoplastic elastomer particularly styrene−diene block copolymers or saturated styrene−diene block copolymers. The styrene−based thermoplastic elastomer comprises blocks of hard segments, e.g. polystyrene, and blocks of soft segments, e.g., polyisoprene, polybutadiene, poly(ethylene−propylene), poly(ethylene−butylene), and polypropylene. Thus, useful styrene−based elastomers may comprise, for example, blocks of polystyrene and blocks of polyisoprene, or blocks of polystyrene and blocks of polybutadiene, or blocks of polystyrene and blocks of poly(ethylene−butadiene). The soft segments of the styrene−based elastomer are preferably substantially saturated, e.g., such polymers as poly(ethylene−propylene), poly(ethylene−butylene), because it has been found that adhesive compositions of the invention in which the styrene−based thermoplastic elastomers comprise such segments tend to have better resistance to oxidative degradation when heated. The styrene−based elastomers are preferably styrene−terminated because such block

3

copolymers tend to have higher elasticity.

The polystyrene blocks, sometimes referred to herein as A blocks, preferably have weight average molecular weights between about 5,000 and about 125,000, and more preferably between about 8,000 and about 45,000. Adhesive compositions wherein the A blocks have molecular weights substantially higher than this range may tend to be have higher viscosity than desired for convenient handling, whereas those comprising A blocks having substantially lower molecular weights may tend to be too brittle. The blocks of the soft segments, sometimes referred to herein as B blocks, preferably have weight average molecular weights between about 30,000 and about 125,000, and more preferably between about 50,000 and about 100,000.

Preferably the styrene – based thermoplastic elastomer comprises a weight ratio of A to B blocks of between about 1:4 and 4:1. Adhesive compositions wherein the weight ratio is substantially lower than about 1:4 may tend to be excessively soft such that bonds provided therewith have less strength, whereas those compositions comprising styrene – based thermoplastic elastomers wherein the weight ratio is substantially higher than about 4:1 may tend to be more brittle.

Examples of styrene – based thermoplastic elastomers that are useful in the present invention and which are commercially available from Shell Chemical Company include styrene – ethylene – butylene – styrene block copolymers, e.g., KRATON G – 1650, G – 1652, and G – 1657; styrene – butadiene – styrene block copolymers, e.g., KRATON D – 1101 and D – 1102; styrene – isoprene – styrene block copolymer, e.g., KRATON D – 1107, D – 1111, D – 1112, and D – 1117; styrene – ethylene – propylene block copolymer, e.g., KRATON G – 1701 and G – 1702; styrene – isoprene block copolymer, e.g., KRATON D – 1320; and styrene – butadiene block copolymer, e.g., KRATON D – 1118. Blends or mixtures of such block copolymers, e.g., KRATON G – 1726X, a blend of styrene – ethylene – butylene – styrene block copolymer and styrene – ethylene – butadiene block copolymer, also commercially available from Shell Chemical Company, are also useful in adhesive compositions of the invention. The G – series KRATONS, which are substantially saturated, are, for that reason, typically preferred for use in compositions of the invention over the D – series KRATONS which are not saturated.

Examples of other commercially available styrene – based thermoplastic elastomers that are suitable for use in the present invention include QUINTAC 3420, 3430, and 3435, available from Japanese Zeon Co., Ltd., and SIS – 5000, available from Japan Synthetic Rubber Co., Ltd. (styrene – isoprene – styrene block copolymers); and SOLPRENE T – 411, T – 414, and T – 475, available from Phillips Petroleum Co., TUF – PRENE A and ASAPRENE T – 431, available from Asahi Chemical Industry Company Co., Ltd., and TR – 1000, and TR – 2000, available from Japan Synthetic Rubber Co., Ltd. (styrene – butadiene – styrene block copolymers).

Adhesive compositions of the invention contain between 2 and 70, and preferably contain between 2 and 60, weight percent of styrene – based thermoplastic elastomer, depending upon the specific properties desired of the resultant composition. Adhesive compositions comprising lesser amounts of styrene – based elastomer, while typically tending to have higher shock resistance and shear strength, may tend to have poorer thermal shock resistance and mechanical properties, whereas compositions comprising greater proportions of styrene – based elastomer may tend to have higher viscosity and lower ability to wet the substrate, thereby resulting in greater difficulty during handling and use.

The amorphous polypropylene component and styrene – based elastomer component of adhesive compositions of the invention tend to be immiscible such that mixtures thereof form discrete domains or distinct phases. While we do not wish to be bound be this theory, it is believed that the exceptional shock resistance and cold temperature properties of adhesives of the invention are due, at least in part, to such phase – separation structure whereby stresses upon the adhesive bond are more effectively internally absorbed at the finely dispersed styrene – based elastomer phase without failure of the bond.

The phase – separation structure can be readily observed by adding ruthenium tetroxide dye to such composition and examination by means of a transmission – type electron microscope. Under such con – ditions, the polystyrene blocks of the styrene – based elastomer and amorphous polypropylene phase will appear dark whereas the soft segments of the styrene – based elastomer appear lighter.

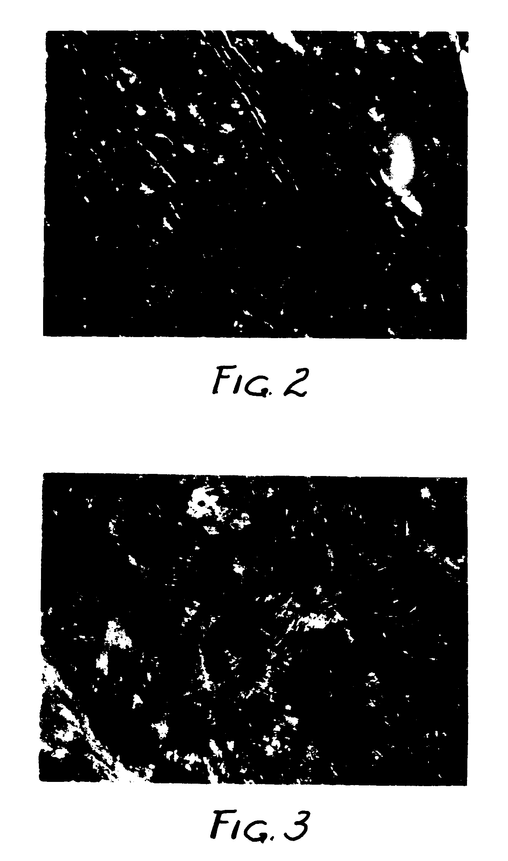

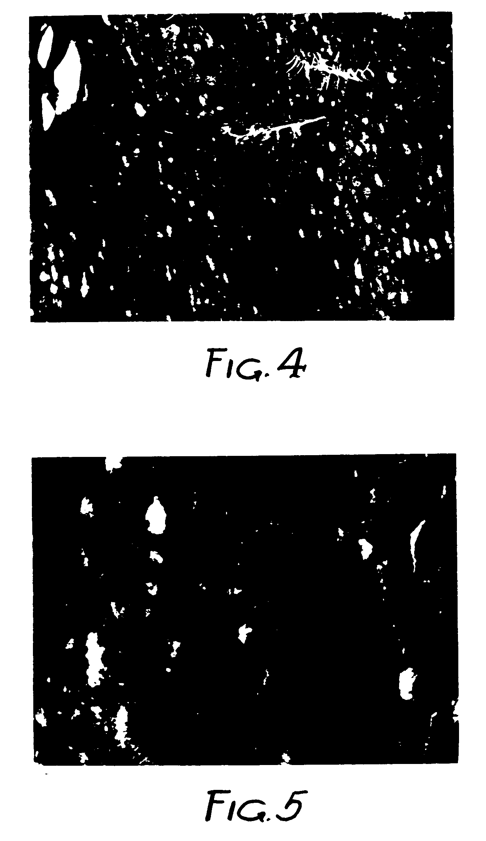

This phase – separation or discrete domain structure may be observed in Figures 2 – 5 which are photomicrographs of compositions of the invention taken with a transmission – type electron microscope. Figure 2 is a 10,000 time enlarged view of the adhesive composition prepared in Example 45 and Figure 3 is a 30,000 time enlarged view of the same composition. Figure 4 is 3,000 time enlarged view of the adhesive composition prepared in Example 46 and Figure 5 is a 10,000 time enlarged view of the same composition.

Adhesive compositions of the invention further typically contain one or more tackifiers. Such tackifier should be compatible with the amorphous polypropylene, i.e., should not separate upon standing in liquid or

4

molten form, and is preferably highly oxidatively stable. Among the naturally − occurring resins which may be used are polyterpenes, rosins, rosin esters and derivatives thereof, of which the more fully hydrogenated forms thereof tend to be preferred because of the light color and high oxidative stability they typically tend to impart to the composition. Five and nine carbon hydrocarbon resins, preferably those which are substantially free of hydrophilic functional groups, may be used as tackifiers. Various synthetically − produced tackifying resins may also be employed, examples of which include aliphatic and aromatic resins, with the fully hydrogenated forms thereof again being preferred. Examples of other resins which may be used include modified terpenes, coumarone − indenes, polyesters, alkyl phenols, and styrene oligomers. Mixtures of the aforedescribed tackifiers may also be used.

The tackifier is present in effective amount, typically not exceeding the proportion of amorphous polypropylene in the composition, to lower the melt viscosity of the composition and improve its ability to wet out the substrate, thereby improving adhesion to the substrate. Thus, adhesive compositions of the invention contain from 1 weight percent to 35 weight percent of tackifier.

Adhesive compositions of the invention also contain up to 24, most typically between 2 and 20, weight percent of one or more waxes, which are included therein to improve the set times of the adhesive composition, alter its viscosity to improve the handling characteristics thereof, and/or increase the hardness of the bond provided therewith. Well − known waxes used in hot melt adhesives, such as low molecular weight polyethylene, microcrystalline wax, Fischer − Tropsch wax, synthetic hydrocarbon wax, and paraffin wax, are examples of suitable waxes for use in the present invention.

Adhesive compositions of the invention may also further contain one or more other agents depending upon the properties desired thereof for a particular application. Examples of some of such agents or additives include minor amounts of crystalline polyolefins, e.g., crystalline polypropylene or polyethylene, to shorten the set time of the embodiment of the invention, fillers, e.g., fumed silica, talc, clay, glass microspheres, plastic microbubbles, etc., colorants, e.g., titanium dioxide, antioxidants, and stabilizers.

Preparation of the adhesive composition by mixing the components and desired additives as described above may be done in conventional manner whereby the components can be completely mixed to ensure that a substantially uniform blend is achieved. The compatibility of the amorphous polypropylene and styrene − based elastomer components is typically such that mixing and dispersion of the components is preferably done by such known techniques as high shear mixing so that the particles of styrene − based thermoplastic elastomer phase and those of amorphous polypropylene phase are reduced to about 100 microns or less, more preferably to about 50 microns or less, and ideally to about 10 microns or less, in order to ensure that a substantially uniform and homogeneous composition results. Thus, the amorphous polypropylene and styrene − based thermoplastic elastomer, which are typically substantially viscous materials, are preferably first added to the mixing vessel and mixed with a high shear technique to ensure that effective mixing is achieved and that agglomerates or globules of such components will be broken up. Typically, the components are continuously mixed at a sufficiently high temperature for the mixture to be in a molten state until a homogeneous mixture is attained.

Examples

The invention will now be further explained with the following illustrative examples. All amounts are expressed in parts by weight unless otherwise indicated.

The following abbreviations are sometimes used herein:

| Abbreviation | Meaning |
|---|---|
| ASTM | American Standards of Testing Materials |
| JIS | Japanese Industrial Standard |
| mPa | milli-Pascal |
| cm | centimeter |
| mm | millimeter |

Unless otherwise indicated, the test procedures referred to in the examples were performed as follows.

Ring and Ball Softening Point

Ring and Ball Softening Point, referred to herein as "R&B", was determined according to ASTM E – 28.

Congealing Point

Congealing Point, referred to herein as "CP", was determined according to ASTM D – 938.

Vicat Softening Point

Vicat Softening Point, referred to herein as "Vicat", was determined according to ASTM D – 1525.

Viscosity

Viscosity was determined at 180°C using a Brookfield RVT and #27 spindle at 20 rpm in accordance with ASTM D – 4402.

Deadload Heat Resistance

Deadload Heat Resistance is the temperature at which a 2.54 centimeter by 2.54 centimeter bond of Douglas Fir to Douglas Fir will support a 200 gram load in static shear for 30 minutes. Averages for three specimens were taken.

Overlap Shear Strength

Overlap Shear Strength, herein referred to as "OLS", was determined using clean, dry test strips with an overlap bond 2.54 centimeters wide having a bondline thickness of about 0.33 millimeters tested with an Instron Tester at a crosshead speed of about 5.1 centimeters/minute. Unless otherwise indicated, results are reported as kilograms – force/centimeter$^2$.

Tension Loading Shear Strength

Tension Loading Shear Strength, herein referred to as "TLS", was determined according to ASTM D – 3164 and D – 1002 (same procedure as JIS K 6850) at a tension rate of 50 millimeters/minute.

Impact Shear Strength

Impact Shear Strength was determined according to ASTM D – 950 (same procedure as JIS K 6855) using 12.5 millimeter wide Birch wood. Unless otherwise indicated, results are reported as (kilograms – force)(centimeter)/centimeter$^2$.

Thermal Shock Cycle

Thermal Shock Cycle was determined by bonding several electronic components (0.6 centimeter diameter axial capacitors) onto epoxy glass boards with the adhesive composition being tested, substan – tially embedding the electronic components in the adhesive composition, and exposing the specimens to up to 40 cold and hot cycles. Each cycle comprised immersion for about 5 minutes in 3M FLUORINERT Brand Liquid FC – 77 at a temperature of about – 40°C, followed by immersion for about 5 minutes in 3M FLUORINERT Brand Liquid FC – 40 at a temperature of about 90°C. The number of failed specimens, i.e., those which separated from or fell off the epoxy glass boards, was noted and reported as percentage of failures.

Volume Resistivity

Volume Resistivity, referred to herein as resistivity, was determined at 23°C according to ASTM D – 257 (same test procedure as JIS K 6911).

Dielectric Strength

Dielectric strength was determined at 23°C according to ASTM D – 149 (same test procedure as JIS K 6911).

Dielectric Constant

Dielectric constant was determined at 23°C and 1 kilohertz according to ASTM D – 150 (same test procedure as JIS K 6911).

Dissipation Factor

Dissipation factor was determined at 23°C and 1 kilohertz in accordance with ASTM D – 150 (same procedure as JIS K 6911).

Electrolytic Corrosion

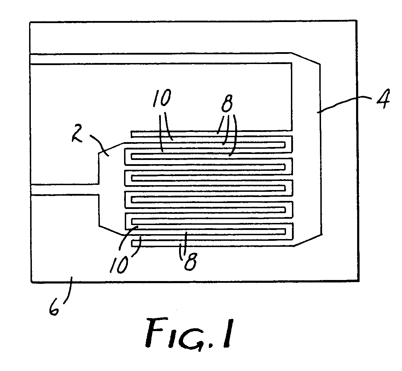

Electric Corrosion was determined by a test hereinafter known as the Residual Insulation Test and comprising embedding a comb electrode having about 0.8 millimeter circuit width and about a 0.8 millimeter spacing in a 1 millimeter thick coating of the adhesive being tested on a glass epoxy board without solder resist. The specimen was exposed to 95% relative humidity at 60°C while causing a 100 volt DC potential between the electrodes for the indicated period. After causing a 500 volt DC potential for 1 minute between the electrodes, insulation resistance was measured at 23°C. A schematic view of the test electrode is illustrated in Figure 1 wherein is shown circuit members 2 and 4 with protruding members 8 that are arrayed in spaced fashion separated by spacings 10. During the test, opposing voltage potentials will be applied to circuit members 2 and 4, e.g., positive and negative, respectively.

180° Peel Strength

180° Peel Strength was determined according to JIS K 6854 at a tension rate of 50 millimeters/minute. This test method provided a minimum value of 2.0 kilograms/25 mm – width.

## Example 1

Example 1 illustrates an embodiment of the invention.
To a clean, steel can on a hot plate, the following components:

```
Component                                                  Amount
EASTOBOND G-92 - atactic polypropylene having
           a R&B of about 145°C, available from
           Eastman Chemical Products, Inc.                  35.64

ARKON P-125 - petroleum resin having a R&B of
           about 125°C, as tackifier.                       24.75
PARAFLINT H-1 - Fischer-Tropsch Wax having a
           CP of about 95°C, available from
           Moore & Munger, Inc.                              9.9

ALLIED AC-617 - low molec. wt. polyethylene having
           a R&B of about 102°C, available from
           Allied Chemical.                                  9.9

TENITE 625 - crystalline polypropylene having a
           Vicat between about 58° and 85°C, available
           from Eastman Chemical Products.                   3.96

IRGANOX 1010 - tetrakis[methylene-3-(3',5'-di-t-
           butyl-4'-hydroxyphenyl)propionate]methane,
           available from Ciba-Geigy Corp., as
           antioxidant                                       0.9
```

were added and heated to about 194°C. After the contents had become fluid, slow stirring was begun using a 5 centimeter diameter Cowles blade driven by an air mixer. When the mixture had become homogeneous, 14.85 parts of KRATON G − 1657, styrene − ethylene − butylene − styrene block copolymer having a specific gravity of about 0.90 was added while stirring. The mixture was then heated to about 205°C and the mixing speed raised to about 1500 rpm. These conditions were maintained for between about 45 and 90 minutes until the mixture had attained a smooth, uniform appearance. The mixture was then cast into rods and cooled. The resultant hot melt adhesive was then tested. The results were as follows.

```
Property                                       Result
R&B                                            149°C
Viscosity (mPa)                                6125
Deadload Heat Resis.                           180°C
Therm. Shock Cyc. (failures)                   0.0%
OLS at 25°C
    Douglas Fir to same                        15.5
    Polyethylene to same                       17.2
    FR-4* to same                              18.7
Volume Resistivity (x10^{17} ohm-cm)           6.7
Dielectric Strength (kilovolt/mm)              51
Dielectric Constant                            2.3
Dissipation Factor                             0.0010
-------------------------------------------------------
*FR-4 is a glass reinforced epoxy circuit board
```

These results illustrate the excellent adhesive and electrical properties provided by an adhesive composition of the invention.

Example 2 and Comparative Example A

Example 2 and Comparative Example A were prepared using the following components:

```
Component              Ex. 2     Comp. Ex. A
EASTOBOND G-92         40.8          48
ARKON P-125            25.4          30
PARAFLINT H-1           9.4          11
ALLIED AC-617           9.4          11
KRATON G-1657          15.0          --
```

The respective mixtures were prepared by placing the aforementioned components in a clean steel container and heating. When the components were nearly molten, stirring was initiated using a 4 centimeter sigma blade and the temperature raised to about 180°C. Each mixture was then continuously stirred at 2000 rpm, and the temperature raised to about 200°C until the mixtures were each homogeneous.

The respective mixtures were then cast into rods and cooled. The resultant hot melt adhesives were then tested. The results for each composition are tabulated in Table I.

## Table I

| Property | Ex. 2 | Co. Ex. A |
|---|---|---|
| Viscosity(mPa) | 6600 | 990 |
| Impact Shear Strength | | |
| at 4°C | 5.0 | 1.0 |
| at 25°C | 17.9 | 1.2 |
| Therm. Shock Cyc. (%failure) | | |
| after 3 cycles | 0 | 90 |
| after 6 cycles | 0 | 90 |
| after 30 cycles | 0 | 100 |
| Volume Resistivity ($\times 10^{17}$ ohm-cm) | 2.0 | 3.5 |
| Dielectric Strength (kilovolt/mm) | 28 | 40 |
| Dielectric Constant (at 1 kilohertz) | 2.4 | 2.3 |
| Dissipation Factor | 0.0015 | 0.0010 |
| Electrolytic Corrosion ($\times 10^{10}$ ohm) | | |
| initial | 7000 | 7000 |
| after 500 hours | 60 | 6 |
| after 1000 hours | 50 | 3 |
| | | |
| Adhesion Properties | | |
| OLS at 25°C (kilograms/$cm^2$) | | |
| Polyvinyl chloride to same | 18.3 | 8.8 |
| TLS at 0°C (kilograms/$cm^2$) | | |
| Polypropylene to same | 27.5 | 5.1 |
| Polyethylene to same | 17.6 | 2.6 |
| Polyacetal to same | 11.6 | 1.6 |
| Polyvinyl chloride to same | 17.0 | 2.5 |
| Nylon-6 to same | 12.7 | 1.8 |
| Nylon-6.6 to same | 24.0 | 1.9 |
| Polybutylene terephthalate to same | 13.0 | 2.1 |
| Polyphenylene oxide to same | 17.7 | 3.1 |
| Polycarbonate to same | 16.8 | 2.2 |
| Acrylonitrile-butadiene-styrene to same | 21.3 | 4.1 |
| Epoxy glass to same | 24.5 | 8.7 |
| Phenolic resin to same | 20.2 | 5.5 |
| Birch wood to same | 54.9 | 18.9 |

```
180° Peel at 25°C (kilograms/25 mm-width)
        Polypropylene to canvas          13.0        4.5
        Polyethylene to canvas           15.0        4.5
        Polyacetal to canvas              9.0        3.5
        Nylon-6 to canvas                12.5        4.0
        Nylon-6.6 to canvas              16.0        4.5
        Polybutylene terephthalate
                to canvas                12.0        4.0
        Polyphenylene oxide to canvas     9.5        2.0
        Polycarbonate to canvas          11.0        3.0
        Acrylonitrile-butadiene-
                styrene to canvas        10.5        1.0
        Epoxy glass to canvas            14.5        2.0
        Phenolic resin to canvas         13.0        2.0
        Birch wood to canvas             14.0        4.0

180° Peel at 0°C (kilograms/25 mm-width)
        Polypropylene to canvas           7.0        2.0
        Polyethylene to canvas            6.0        2.5
        Polyacetal to canvas              5.0        2.0
        Nylon-6 to canvas                 6.5        2.0
        Nylon-6.6 to canvas               6.5        2.0
        Polybutylene terephthalate
                to canvas                 6.0        2.0
        Polyphenylene oxide to canvas     3.5        2.0
        Polycarbonate to canvas           5.5        2.0
        Acrylonitrile-butadiene-
                styrene to canvas         3.5        2.0
        Epoxy glass to canvas             6.5        2.0
        Phenolic resin to canvas          5.0        2.0
        Birch wood to canvas              6.0        2.0
```

Example 2 and Comparative Example A illustrate the excellent adhesion, corrosion resistance, and thermal shock resistance properties of an adhesive composition of the invention, and illustrate the improvement of those properties in a hot melt adhesive composition which comprises a styrene – based elastomer in accordance with the invention.

Examples 3 – 10

Examples 3 – 10 illustrate the use of varying amounts of styrene – isoprene – styrene block copolymer in adhesive compositions of the invention.

The compositions in Examples 3 – 6 were made as in Example 2. In Examples 7 – 10, due to the higher viscosity of the mixtures, the styrene – isoprene – styrene block copolymer, amorphous polypropylene, and tackifying resin were first melted and mixed with a sigma – type kneader at about 180°C and then mixed with the other components as in Examples 3 – 6.

The compositions of the adhesives made in these Examples and the properties thereof are tabulated in Table II.

Table II

| Example No. | Com. Ex. A. | 3 | 4 | 5 | 6 | 7 | 8 | 9 | 10 |
|---|---|---|---|---|---|---|---|---|---|
| **Component** | | | | | | | | | |
| EASTOBOND G-92 | 48 | 47.0 | 45.7 | 43.2 | 40.8 | 38.4 | 33.7 | 24.1 | 14.5 |
| ARKON P-125 | 29.4 | 30 | 28.5 | 27.0 | 25.4 | 24.0 | 20.9 | 14.9 | 8.9 |
| PARAFLINT H-1 | 11 | 10.8 | 10.4 | 9.9 | 9.4 | 8.8 | 7.7 | 5.5 | 3.3 |
| ALLIED AC-617 | 11 | 10.8 | 10.4 | 9.9 | 9.4 | 8.8 | 7.7 | 5.5 | 3.3 |
| KRATON D-1107 | -- | 2.0 | 5.0 | 10.0 | 15.0 | 20.0 | 30.0 | 50.0 | 70.0 |
| **Property** | | | | | | | | | |
| Viscosity (mPa) | 990 | 1030 | 1130 | 1290 | 2130 | 2210 | 4430 | 25,000 | >500,000 |
| Impact Shear Strength | | | | | | | | | |
| at 4 C | 1.0 | 1.4 | 1.4 | 1.8 | 2.6 | 3.1 | 3.4 | 11.7 | 13.0 |
| at 25 C | 1.2 | 1.7 | 2.0 | 2.4 | 5.8 | 4.3 | 5.6 | 14.0 | 16.0 |
| TLS Strength | | | | | | | | | |
| at 0 C | 2.5 | 3.8 | 4.7 | 4.2 | 5.3 | 8.8 | 9.0 | 11.1 | 5.6 |
| at 25 C | 8.8 | 14.4 | 18.1 | 8.3 | 13.4 | 6.2 | 3.0 | 3.9 | 1.7 |

These results show the use of a styrene – isoprene – styrene block copolymer at between about 2 and about 70 weight percent in an adhesive composition of the invention, to provide improved impact strength and, particularly at low temperatures, improved tension loading shear strength.

12

Examples 11 – 17

Examples 11 – 17 illustrate the use of varying amounts of styrene – ethylene – butylene – styrene block copolymer in adhesive compositions of the invention.

The compositions in Examples 11 – 14 and 15 – 17 were made as in Examples 3 – 6 and 7 – 10, respectively. The compositions of the adhesives made these Examples and the properties thereof are tabulated in Table III.

Table III

| Example No. | Com. Ex. A. | 11 | 12 | 13 | 14 | 15 | 16 | 17 |
|---|---|---|---|---|---|---|---|---|
| **Component** | | | | | | | | |
| EASTOBOND G-92 | 48 | 47.0 | 45.7 | 43.2 | 40.8 | 38.4 | 33.7 | 24.1 |
| ARKON P-125 | 29.4 | 30 | 28.5 | 27.0 | 25.4 | 24.0 | 20.9 | 14.9 |
| PARAFLINT H-1 | 11 | 10.8 | 10.4 | 9.9 | 9.4 | 8.8 | 7.7 | 5.5 |
| ALLIED AC-617 | 11 | 10.8 | 10.4 | 9.9 | 9.4 | 8.8 | 7.7 | 5.5 |
| KRATON D-1652 | -- | 2.0 | 5.0 | 10.0 | 15.0 | 20.0 | 30.0 | 50.0 |
| **Property** | | | | | | | | |
| Viscosity (mPa) | 990 | 1210 | 1720 | 3220 | 7380 | 20,000 | 210,000 | >500,000 |
| Impact Shear Strength | | | | | | | | |
| at 4 C | 1.0 | 1.2 | 1.3 | 1.4 | 2.2 | 2.7 | 8.7 | 8.4 |
| at 25 C | 1.2 | 1.4 | 2.0 | 2.1 | 6.5 | 7.3 | 10.7 | 10.2 |
| TLS Strength | | | | | | | | |
| at 0 C | 2.5 | 3.2 | 4.0 | 6.3 | 6.4 | 7.9 | 18.6 | 13.0 |
| at 25 C | 8.8 | 16.6 | 20.7 | 24.4 | 23.7 | 22.6 | 16.5 | 10.0 |

These results show the use of a styrene–ethylene–butylene–styrene block copolymer at between about 2 and 50 weight percent in an adhesive composition of the invention to provide improved impact strength and, particularly at low temperatures, improved tension loading shear strength.

14

Examples 18 – 24

Examples 18 – 24 illustrate the use of varying amounts of SEP block copolymer in adhesive composi – tions of the invention.

The compositions in Examples 18 – 21 and 22 – 24 were made as in Examples 3 – 6 and 7 – 10, respectively. The compositions of the adhesives made in these Examples and the properties thereof are tabulated in Table IV.

Table IV

| Example No. | Com. Ex. A. | 18 | 19 | 20 | 21 | 22 | 23 | 24 |
|---|---|---|---|---|---|---|---|---|
| Component | | | | | | | | |
| EASTOBOND G-92 | 48 | 47.0 | 45.7 | 43.2 | 40.8 | 38.4 | 33.7 | 24.1 |
| ARKON P-125 | 30 | 28.5 | 27.3 | 25.4 | 24.0 | 20.9 | 14.9 | |
| PARAFLINT H-1 | 11 | 10.8 | 10.4 | 9.9 | 9.4 | 8.8 | 7.7 | 5.5 |
| ALLIED AC-617 | 11 | 10.8 | 10.4 | 9.9 | 9.4 | 8.8 | 7.7 | 5.5 |
| KRATON G-1702 | — | 2.0 | 5.0 | 10.0 | 15.0 | 20.0 | 30.0 | 50.0 |
| | | | | | | | | |
| Property | | | | | | | | |
| Viscosity (mPa) | 990 | 1430 | 2400 | 7130 | 122,500 | ----->500,000----- | | |
| Impact Shear Strength | | | | | | | | |
| at 4°C | 1.0 | 1.2 | 1.4 | 1.5 | 1.8 | 18.6 | 18.6 | 12.4 |
| at 25°C | 1.2 | 1.5 | 1.6 | 11.9 | 16.0 | 13.6 | 14.1 | 11.7 |
| TLS Strength | | | | | | | | |
| at 0°C | 2.5 | 3.3 | 5.1 | 5.0 | 7.2 | 25.1 | 26.6 | 13.7 |
| at 25°C | 8.8 | 17.0 | 26.9 | 24.5 | 23.0 | 16.9 | 11.8 | 6.7 |

These results show the use of a styrene – ethylene – propylene block copolymer at between about 2 and 50 weight percent in an adhesive composition of the invention to provide improved impact strength and, low temperatures, improved tension loading shear strength.

Examples 25 – 28

Examples 25 – 28 illustrate the use of other styrene – based thermoplastic elastomers in adhesive compositions of the invention.

The compositions were made as in Examples 7 – 10 except that the indicated amounts of the indicated block copolymers were used in place of styrene – isoprene – styrene. The compositions of the specimens and the properties thereof are tabulated in Table V.

Table V

| Example | 25 | 26 | 27 | 28 |
|---|---|---|---|---|
| Component | | | | |
| EASTOBOND G-92 | 33.7 | 38.4 | 38.4 | 38.4 |
| ARKON P-125 | 20.9 | 24.0 | 24.0 | 24.0 |
| PARAFLINT H-1 | 7.7 | 8.8 | 8.8 | 8.8 |
| ALLIED AC-617 | 7.7 | 8.8 | 8.8 | 8.8 |
| KRATON D-1102 | 30 | -- | -- | -- |
| KRATON D-1320 | -- | 20 | -- | -- |
| KRATON D-1184 | -- | -- | 20 | -- |
| KRATON D-1118 | -- | -- | -- | 20 |
| | | | | |
| Property | | | | |
| Viscosity (mPa) | 8000 | 9150 | 12000 | 3250 |
| Impact Shear Strength | | | | |
| at 4°C | 2.4 | 1.5 | 1.6 | 1.6 |
| at 25°C | 2.2 | 2.7 | 2.1 | 2.1 |
| TLS Strength | | | | |
| at 0°C | 4.4 | 4.2 | 5.8 | 5.6 |
| at 25°C | 17.8 | 14.7 | 21.3 | 17.6 |

Examples 29 – 36

Examples 29 – 36 illustrate the use of different atactic polypropylenes in adhesive compositions of the invention.

17

The compositions of these specimens and the properties thereof are tabulated in Table VI.

Table VI

| Example | 29 | 30 | 31 | 32 | 33 | 34 | 35 | 36 |
|---|---|---|---|---|---|---|---|---|
| Component | | | | | | | | |
| APP (R&B 115°C)* | 47.0 | 43.2 | 40.8 | 38.4 | — | — | — | — |
| APP (R&B 138°C)** | — | — | — | — | 47.0 | 43.2 | 40.8 | 38.4 |
| ARKON P-125 | 29.4 | 27.0 | 25.4 | 24.0 | 29.4 | 27.0 | 25.4 | 24.0 |
| PARAFLINT H-1 | 10.8 | 9.9 | 9.4 | 8.8 | 10.8 | 9.9 | 9.4 | 8.8 |
| ALLIED AC-617 | 13.8 | 9.9 | 9.4 | 8.8 | 10.8 | 9.9 | 9.4 | 8.8 |
| KRATON G-1657 | 2.0 | 10.0 | 15.0 | 20.0 | 2.0 | 10.0 | 15.0 | 20.0 |
| Property | | | | | | | | |
| Viscosity (mPa) | 330 | 1084 | 2580 | 5350 | 850 | 2840 | 5430 | 9410 |
| Impact Shear Strength | | | | | | | | |
| at 4°C | 1.7 | 2.2 | 3.0 | 15.0 | 2.0 | 2.8 | 4.1 | 16.2 |
| at 25°C | 3.0 | 14.2 | 14.9 | 16.1 | 2.4 | 12.2 | 17.9 | 18.5 |
| TLS Strength | | | | | | | | |
| at 0°C | 1.0 | 17.7 | 28.8 | 28.4 | 5.8 | 15.4 | 29.2 | 26.2 |
| at 25°C | 17.4 | 17.7 | 17.4 | 16.7 | 19.6 | 17.5 | 16.2 | 14.0 |

*Available from Chisso Company.
**Available from Mitsui Toatsu Chemicals, Inc.

Examples 37 – 44 and Comparative Examples B – I

Examples 37 – 44 and respective Comparative Examples B – I illustrate the use of different tackifying resins and waxes in adhesive compositions of the invention.

The compositions were prepared as in Examples 7 – 10. The compositions and properties of the specimens of these examples are tabulated below.

18

Table VII

| Component | Ex. 37 | Comp.Ex.B |
|---|---|---|
| EASTOBOND G-92 | 40.8 | 48 |
| CLEARON P-125 | 25.4 | 30 |
| PARAFLINT H-1 | 9.4 | 11 |
| ALLIED AC-617 | 9.4 | 11 |
| KRATON G-1657 | 15.0 | -- |
| Properties | | |
| Viscosity (mPa) | 5880 | 920 |
| Impact Shear Strength | | |
| at 4°C | 6.3 | 1.0 |
| at 25°C | 17.9 | 2.2 |
| TLS Strength | | |
| at 0°C | 16.4 | 3.7 |
| at 25°C | 19.7 | 18.2 |

Table VIII

| Component | Ex. 38 | Comp.Ex.C |
|---|---|---|
| EASTOBOND G-92 | 40.8 | 48 |
| ARKON P-125 | 25.4 | 30 |
| HI-MIC-2095* | 9.4 | 11 |
| ALLIED AC-617 | 9.4 | 11 |
| KRATON G-1657 | 15.0 | -- |
| Properties | | |
| Viscosity (mPa) | 6590 | 950 |
| Impact Shear Strength | | |
| at 4°C | 11.6 | 1.6 |
| at 25°C | 18.0 | 2.6 |
| TLS Strength | | |
| at 0°C | 18.5 | 4.6 |
| at 25°C | 16.2 | 20.4 |

*Microcrystalline was having a melting point of 96°C, available from Nippon Seiro Co.

The composition in Comparative Example C was observed to have higher tension loading shear strength than the composition of Example 38 at 25°C, however, the former was also observed to be very brittle whereas the composition of Example 38 was substantially more elastic in nature.

### Table IX

| Component | Ex. 39 | Comp.Ex.D |
|---|---|---|
| Polypropylene* | 40.8 | 48 |
| HITANOL 1501 | 25.4 | 30 |
| Paraffin Wax 155** | 9.4 | 11 |
| PARAFLINT H-1 | 9.4 | 11 |
| KRATON D-1107 | 15.0 | --- |
| | | |
| Properties | | |
| Viscosity (mPa) | 390 | 75 |
| Impact Shear Strength | | |
| at 4°C | 2.3 | 0.7 |
| at 25°C | 5.7 | 0.9 |
| TLS Strength | | |
| at 0°C | 7.7 | 0.5 |
| at 25°C | 4.6 | 0.4 |

*Atactic polypropylene having a R&B of 115°C, available from Chisso Co.
**Paraffin wax having a melting point of 69°C, available from Nippon Seiro Co.

### Table X

| Component | Ex. 40 | Comp.Ex.E |
|---|---|---|
| EASTOBOND G-92 | 35.2 | 44 |
| DUREZ RR 12603 | 30.4 | 38 |
| PARAFLINT H-1 | 14.4 | 18 |
| TUFPRENE A | 20.0 | -- |
| | | |
| Properties | | |
| Viscosity (mPa) | 2500 | 2250 |
| Impact Shear Strength | | |
| at 4°C | 2.6 | 1.7 |
| at 25°C | 8.1 | 6.1 |
| TLS Strength | | |
| at 0°C | 26.8 | 23.4 |
| at 25°C | 15.7 | 13.6 |

## Table XI

| Component | Ex. 41 | Comp.Ex.F |
|---|---|---|
| Polypropylene* | 35.0 | 43.8 |
| DYMEREX | 15.0 | 18.8 |
| ESTER GUM H | 10.0 | 12.5 |
| Paraffin Wax 155** | 10.0 | 12.5 |
| ALLIED AC-617 | 10.0 | 12.5 |
| KRATON G-1652 | 20.0 | -- |
| | | |
| Properties | | |
| Viscosity (mPa) | 1320 | 90 |
| Impact Shear Strength | | |
| at 4°C | 17.4 | 0.8 |
| at 25°C | 10.2 | 4.3 |
| TLS Strength | | |
| at 0°C | 32.1 | 1.0 |
| at 25°C | 16.9 | 0.7 |

\*Atactic polypropylene having a R&B of 115°C, available from Chisso Co.
\*\*Paraffin wax having a melting point of 69°C, available from Nippon Seiro Co.

## Table XII

| Component | Ex. 42 | Comp.Ex.G |
|---|---|---|
| EASTOBOND G-92 | 40.8 | 48 |
| CUMARONE-120 | 25.4 | 30 |
| PARAFLINT H-1 | 9.4 | 11 |
| ALLIED AC-617 | 9.4 | 11 |
| KRATON G-1657 | 15.0 | -- |
| | | |
| Properties | | |
| Viscosity (mPa) | 75,000 | 1610 |
| Impact Shear Strength | | |
| at 4°C | 11.9 | 4.4 |
| at 25°C | 9.6 | 7.4 |
| TLS Strength | | |
| at 0°C | 11.7 | 5.5 |
| at 25°C | 15.3 | 7.9 |

## Table XIII

| Component | Ex. 43 | Comp.Ex.H |
|---|---|---|
| EASTOBOND G-92 | 40.8 | 48 |
| PICCOLASTIC D-125 | 25.4 | 30 |
| PARAFLINT H-1 | 9.4 | 11 |
| ALLIED AC-617 | 9.4 | 11 |
| KRATON G-1657 | 15.0 | -- |

Properties
Viscosity (mPa)                  0,000      2065
Impact Shear Strength
     at  4°C                     14.6        6.2
     at 25°C                      8.1        5.8
TLS  Strength
     at  0°C                     13.7        4.7
     at 25°C                     10.1        0.2

## Table XIV

| Component | Ex. 44 | Comp.Ex.I |
|---|---|---|
| Polypropylene* | 35.2 | 44 |
| VYLON GX 250 | 30.4 | 38 |
| HI-MIC-2095 | 14.4 | 18 |
| JSR SIS-5000 | 20.0 | -- |

Properties
Viscosity (mPa)                  3400        850
Impact Strength
     at  4°C                      2.4        1.3
     at 25°C                      4.2        0.9
TLS  Strength
     at  0°C                      1.6        0.6
     at 25°C                      1.5        1.0
----------------------------------------------------

*Atactic polypropylene having a R&B of 115°C,
 available from Chisso Co.

EP 0 285 430 B1

Examples 45 and 46

The compositions and properties of the adhesives prepared in these Examples were as follows.

Table XV

| Component | 45 | 46 |
|---|---|---|
| Polypropylene* | 45.7 | 40.8 |
| ARKON P-125 | 28.5 | 25.4 |
| Wax** | 10.4 | 9.4 |
| Polyethylene*** | 10.4 | 9.4 |
| KRATON G-1657 | 5.0 | 15.0 |
| | | |
| Properties | | |
| Viscosity (mPa) | 1,900 | 6,680 |
| Impact Strength | | |
| at 4°C | 1.8 | 5.0 |
| at 25°C | 3.3 | 17.9 |
| TLS trength | | |
| at 0°C | 5.5 | 17.0 |
| at 25°C | 24.7 | 18.3 |

\-------------------------------------------
*Atactic polypropylene having a R&B of 145°C.
**Fischer-Tropsch Wax having R & B of 108°C.
***Low molecular weight polyethylene having a R & B of 102°C.

Figures 2−5 are photomicrographs of the compositions of the adhesives prepared in Examples 45 and 46. Test specimens were prepared by immersing a sample of the adhesive composition being studied in a 1 percent aqueous solution of ruthenium tetroxide for 24 hours, cutting by means of a common microtome, and then examining with a trasmission−type electron microscope. The phase−separation structure of the adhesive compositions provided by the invention are readily in Figures 2−5.

Various modifications and alterations of this invention will become apparent to those skilled in the art without departing from the scope and spirit of this invention.

**Claims**

1. A hot−melt adhesive composition consisting essentially of:
   (a) from 10 to 70 weight percent amorphous polypropylene having a weight average molecular weight of between 10,000 and 100,000;
   (b) from 2 to 70 weight percent of styrene based thermoplastic elastomer;
   (c) from 1 to 35 weight percent of tackifier; and
   (d) from 2 to 24 weight percent of wax;
   said hot melt adhesive composition having a dissipation factor of 0.01 or less at 1 kHz at 23˚C and a volume resistivity of at least 1x10$^{14}$ ohm−cm at 23˚C.

2. A composition according to Claim 1 wherein the styrene−based thermoplastic elastomer is a styrene−diene block copolymer or saturated styrene−diene block copolymer.

3. A composition according to either of Claims 1 and 2 wherein the adhesive has an electrolytic corrosion as measured by a Residual Insultation Test as hereinafter defined of between 10$^{10}$ and 10$^{12}$ ohms after 1000 hours.

4. A hot melt adhesive according to any one of Claims 1 to 3 consisting essentially of
   (a) between 14 and 50 weight percent of said amorphous polypropylene;
   (b) between 2 and 60 weight percent of said styrene based elastomer;
   (c) between 1 and 25 weight percent of said tackifiers; and

23

(d) 2 to 24 weight percent of said wax.

5. A hot melt adhesive according to any one of Claims 1 to 4 wherein the polypropylene has a weight average molecular weight of between 10000 and 50000.

6. A hot melt adhesive composition of any one of Claims 1 to 5 wherein said amorphous polypropylene comprises at least one of: atactic polypropylene, and propylene copolymerized with a low molecular weight alkene.

7. A hot melt adhesive composition of any one of Claims 1 to 6 wherein said stryene – based elastomer has a repeating structure of A – B or A – B – A wherein A is polystyrene and B is a compatible soft segment copolymer.

8. A hot melt adhesive composition of Claim 7 wherein said A blocks have a weight average molecular weight of between 5,000 and 125,000.

9. A hot melt adhesive composition of Claim 7 wherein said A blocks have a weight average molecular weight of between 8,000 and 45,000.

10. A hot melt adhesive composition of any one of Claims 7 to 9 wherein said B blocks have a weight average molecular weight of between 30,000 and 125,000.

11. A hot melt adhesive composition of Claim 10 wherein said B blocks have a weight average molecular weight of between 50,000 and 100,000.

12. A hot melt adhesive composition of any of Claims 7 to 11 wherein the weight ratio of said A blocks to said B blocks is between 1:4 and 4:1.

13. A hot melt adhesive composition of any one of Claims 1 to 12 wherein said styrene – based thermoplastic elastomer comprises blocks of hard segments and blocks of soft segments, said soft segments being substantially saturated.

14. A hot melt adhesive composition of any one of Claims 1 to 13 wherein said tackifier is at least one of the following: a polyterpene, rosin, rosin ester or derivative thereof, five or nine carbon hydrocarbon resin, aliphatic or aromatic resin, modified terpene, coumaroneindene, polyester, alkyl phenol, or styrene oligomer.

15. A hot melt adhesive composition of any one of Claims 1 to 14 wherein said wax is at least one of the following: low molecular weight polyethylene, microcrystalline wax, Fischer – Tropsch wax, synthetic hydrocarbon wax, or paraffin wax.

16. A hot melt adhesive composition of any one of Claims 1 to 15 further characterized in that said composition further comprises at least one of the following: crystalline polyolefin, filler, colorant, antioxidant, or stabilizer.

17. A hot melt adhesive composition according to any one of Claims 1 to 16 which has a volume resistivity of between $10^{14}$ and $10^{17}$ ohm – cm at 23˚C, a dielectric strength of between 25 and 50 kilovolts/millimeter, a dielectric constant of between 2.3 and 3.0 at 1 kilohertz, a dissipation factor of between 0.0008 and 0.010 at 1 kilohertz at 23˚C, and electrolytic corrosion after 1000 hours of between $10^{10}$ and $10^{12}$ ohms.

18. An electronic component characterized in that the hot melt adhesive of any one of Claims 1 to 17 forms the bond therein.

19. A method of bonding electronic components by bonding with a hot melt adhesive wherein the adhesive is an adhesive as defined in any one of Claims 1 to 18.

**Patentansprüche**

1. Schmelzkleberzusammensetzung, im wesentlichen bestehend aus:
   (a) 10 bis 70 Gewichtsprozent amorphem Polypropylen mit einem mittleren Molekulargewicht zwischen 10.00 und 100.000;
   (b) 2 bis 70 Gewichtsprozent thermoplastischem Elastomer auf Styrolbasis;
   (c) 1 bis 35 Gewichtsprozent Klebrigmacher und
   (d) 2 bis 24 Gewichtsprozent Wachs;
   wobei die Zusammensetzung des Schmelzklebers bei 1 kHz und 23 ˚C einen dielektrischen Verlustfaktor von 0,01 oder weniger und einen spezifischen Volumenwiderstand von mindestens $1 \times 10^{14}$ Ohmcm bei 23 ˚C aufweist.

2. Zusammensetzung nach Anspruch 1, bei welcher das thermoplastische Elastomer auf Styrolbasis ein Styrol/Dien − Blockcopolymer oder gesättigtes Styrol/Dien − Blockcopolymer ist.

3. Zusammensetzung nach jedem der Ansprüche 1 und 2, bei welcher der Kleber eine, wie hierin definierte und mit einer Restisolationsprüfung gemessene elektrolytische Korrosion zwischen $10^{10}$ und $10^{12}$ Ohm nach 1.000 Stunden aufweist.

4. Schmelzkleber nach einem der Ansprüche 1 bis 3, im wesentlichen umfassend:
   (a) zwischen 14 und 50 Gewichtsprozent des amorphen Polypropylens;
   (b) zwischen 2 und 60 Gewichtsprozent des Elastomers auf Styrolbasis;
   (c) zwischen 1 und 25 Gewichtsprozent der Klebrigmacher und
   (d) 2 bis 24 Gewichtsprozent des Wachses.

5. Schmelzkleber gemäß einem der Ansprüche 1 bis 4, bei welchem das Polypropylen ein mittleres Molekulargewicht zwischen 10.000 und 50.000 hat.

6. Schmelzkleberzusammensetzung nach einem der Ansprüche 1 bis 5, bei welcher das amorphe Polypropylen mindestens eines von ataktischem Polypropylen und Propylen umfaßt, das mit einem niedermolekularen Alken copolymerisiert ist.

7. Schmelzkleberzusammensetzung nach einem der Ansprüche 1 bis 6, bei welcher das Elastomer auf Styrolbasis eine Staudinger − Einheit von A − B oder A − B − A aufweist, bei der A Polystyrol und B ein kompatibles weiches Segment − Copolymer ist.

8. Schmelzkleberzusammensetzung nach Anspruch 7, bei welcher die A − Blöcke ein mittleres Moleku − largewicht zwischen 5.000 und 125.000 haben.

9. Schmelzkleberzusammensetzung nach Anspruch 7, bei welcher die A − Blöcke ein mittleres Moleku − largewicht zwischen 8.000 und 45.000 haben.

10. Schmelzkleberzusammensetzung nach einem der Ansprüche 7 bis 9, bei welcher die B − Blöcke ein mittleres Molekulargewicht zwischen 30.000 und 125.000 haben.

11. Schmelzkleberzusammensetzung nach Anspruch 10, bei welcher die B − Blöcke ein mittleres Moleku − largewicht zwischen 50.000 und 100.000 haben.

12. Schmelzkleberzusammensetzung nach einem der Ansprüche 7 bis 11, bei welcher das Gewichtsver − hältnis der A − Blöcke zu den B − Blöcken zwischen 1:4 und 4:1 liegt.

13. Schmelzkleberzusammensetzung nach einem der Ansprüche 1 bis 12, bei welcher das thermoplasti − sche Elastomer auf Styrolbasis Blöcke von harten Segmenten und Blöcke von weichen Segmenten umfaßt und die weichen Segmente im wesentlichen gesättigt sind.

14. Schmelzkleberzusammensetzung nach einem der Ansprüche 1 bis 13, bei welcher der Klebrigmacher mindestens einer der folgenden ist: ein Polyterpen, Terpentinharz, Harzsäureester oder deren Derivate, 5 − oder 9 − Kohlenstoff − Kohlenwasserstoffharz, aliphatisches oder aromatisches Kunstharz, modifi −

ziertes Terpen, Cumaron – Inden, Polyester, Alkylphenol oder Styrololigomer.

15. Schmelzkleberzusammensetzung nach einem der Ansprüche 1 bis 14, bei welcher das Wachs mindestens eines der folgenden ist: niedermolekulares Polyethylen, mikrokristallines Wachs, Fischer – Tropsch – Wachs, synthetisches Kohlenwasserstoffwachs oder Paraffinwachs.

16. Schmelzkleberzusammensetzung nach einem der Ansprüche 1 bis 15, ferner dadurch gekennzeichnet, daß die Zusammensetzung ferner mindestens eines der folgenden umfaßt: kristallines Polyolefin, Füllstoff, Färbemittel, Antioxidationsmittel oder Stabilisator.

17. Schmelzkleberzusammensetzung nach einem der Ansprüche 1 bis 16, die einen spezifischen Volumenwiderstand zwischen $10^{14}$ und $10^{17}$ Ohmcm bei 23 °C, eine Durchschlagfestigkeit zwischen 25 und 50 kV/mm, eine Dielektrizitätskonstante zwischen 2,3 und 3,0 bei 1 kHz, einen dielektrischen Verlustfaktor zwischen 0,0008 und 0,010 bei 1 kHz und 23 °C und eine elektrolytische Korrosion nach 1.000 Stunden zwischen $10^{10}$ und $10^{12}$ Ohm aufweist.

18. Elektronisches Bauelement, dadurch gekennzeichnet, daß darin der Schmelzkleber nach einem der Ansprüche 1 bis 17 die Klebung bildet.

19. Verfahren zum Kleben elektronischer Bauelemente durch Kleben mit einem Schmelzkleber, bei welchem der Kleber der Definition nach einem der Ansprüche 1 bis 18 entspricht.

**Revendications**

1. Composition adhésive thermofusible formée essentiellement de :
   (a) 10 à 70 % en poids de polypropylène amorphe d'un poids moléculaire moyen de 10 000 à 100 000 ;
   (b) 2 à 70 % en poids d'élastomère thermoplastique à base de styrène ;
   (c) 1 à 35 % en poids d'agent adhésif ; et
   (d) 2 à 24 % en poids de cire ;
   ladite composition adhésive thermofusible ayant un facteur de perte de 0,01, ou moins, à 1 kHz et 23°C, et une résistivité volumique d'au moins $1 \times 10^{14}$ ohm – cm à 23°C.

2. Composition selon la revendication 1, dans laquelle l'élastomère thermoplastique à base de styrène est un copolymère séquencé styrène – diène ou un copolymère séquencé saturé styrène – diène.

3. Composition selon l'une quelconque des revendications 1 et 2, dans laquelle l'adhésif a une corrosion électrolytique, mesurée au moyen de l'Essai d'Isolation Résiduelle, valant entre $10^{10}$ et $10^{12}$ ohms après 1 000 heures.

4. Adhésif thermofusible selon l'une quelconque des revendications 1 à 3, formée essentiellement de :
   (a) 14 à 50 % en poids dudit polypropylène amorphe;
   (b) 2 à 60 % en poids dudit élastomère à base de styrène ;
   (c) 1 à 25 % en poids desdits agents adhésifs ; et
   (d) 2 à 24 % en poids de ladite cire.

5. Adhésif thermofusible selon l'une quelconque des revendications 1 à 4, dans laquelle le polypropylène a un poids moléculaire moyen compris entre 10 000 et 50 000.

6. Composition adhésive thermofusible selon l'une quelconque des revendications 1 à 5, dans laquelle ledit polypropylène amorphe comprend au moins : un polypropylène atactique ou un propylène copolymérisé avec un alcène de faible poids moléculaire.

7. Composition adhésive thermofusible selon l'une quelconque des revendications 1 à 6, dans laquelle ledit élastomère à base de styrène a une structure répétitive A – B ou A – B – A, dans laquelle A est un polystyrène et B est un copolymère compatible à segments doux.

8. Composition adhésive thermofusible selon la revendication 7, dans laquelle lesdits blocs A ont un poids moléculaire moyen compris entre 5 000 et 125 000.

9. Composition adhésive thermofusible selon la revendication 7, dans laquelle lesdits blocs A ont un poids moléculaire moyen compris entre 8 000 et 45 000.

10. Composition adhésive thermofusible selon l'une quelconque des revendications 7 à 9, dans laquelle lesdits blocs B ont un poids moléculaire moyen compris entre 30 000 et 125 000.

11. Composition adhésive thermofusible selon la revendication 10, dans laquelle lesdits blocs B ont un poids moléculaire moyen compris entre 50 000 et 100 000.

12. Composition adhésive thermofusible selon l'une quelconque des revendications 7 à 11, dans laquelle le rapport pondéral desdits blocs A et desdits blocs B est compris entre 1:4 et 4:1.

13. Composition adhésive thermofusible selon l'une quelconque des revendications 1 à 12, dans laquelle ledit élastomère thermoplastique à base de styrène comprend des blocs de segments durs et des blocs de segments doux, lesdits segments doux étant essentiellement saturés.

14. Composition adhésive thermofusible selon l'une quelconque des revendications 1 à 13, dans laquelle ledit agent adhésif est au moins un des composés suivants : polyterpène, colophane, ester de colophane ou un de ses dérivés, résine hydrocarbonée à cinq ou neuf atomes de carbone, résine aliphatique ou aromatique, terpène modifié, coumarone – indène, polyester, alkylphénol, ou oligomère styrénique.

15. Composition adhésive thermofusible selon l'une quelconque des revendications 1 à 14, dans laquelle ladite cire est au moins un des composés suivants : polyéthylène de faible poids moléculaire, cire microcristalline, cire de Fischer – Tropsch, cire hydrocarbonée synthétique, ou cire de paraffine.

16. Composition adhésive thermofusible selon l'une quelconque des revendications 1 à 15, caractérisée aussi en ce qu'elle comprend en outre au moins un des éléments suivants : polyoléfine cristalline, charge, colorant, anti – oxydant ou stabilisant.

17. Composition adhésive thermofusible selon l'une quelconque des revendications 1 à 16, ayant une resistivité volumique comprise entre $10^{14}$ et $10^{17}$ ohm – cm à 23°C, une résistance diélectrique comprise entre 25 et 50 kilovolts/millimètre, une constante diélectrique comprise entre 2,3 et 3,0 à 1 kilohertz, un facteur de porte compris entre 0,0008 et 0,010 à 1 kilohertz et 23°C, et une corrosion électrolytique comprise entre $10^{10}$ et $10^{12}$ après 1 000 heures.

18. Composant électronique, caractérisé en ce que l'adhésif thermofusible selon l une quelconque des revendications 1 à 17 forme la liaison dans celui – ci.

19. Procédé de fabrication de composants électroniques par assemblage avec un adhésif thermofusible, dans lequel l'adhésif est un adhésif tel que défini dans l'une quelconque des revendications 1 à 18.

FIG. 1

FIG. 2

FIG. 3

FIG. 4

FIG. 5